# EUROPEAN PATENT SPECIFICATION

(11) **EP 1 743 185 B1**
(45) Date of publication and mention of the grant of the patent: **22.09.2010**
(21) Application number: 05718596.9
(22) Date of filing: 30.03.2005
(51) Int. Cl.: G01R 33/28

(54) **ELECTRO-OPTICAL MAGNETIC RESONANCE TRANSDUCER**
ELEKTROOPTISCHER MAGNETRESONANZWANDLER
TRANSDUCTEUR ELECTRO-OPTIQUE DE RESONANCE MAGNETIQUE

(30) Priority: 26.04.2004 US 565375 P
(43) Date of publication of application: 17.01.2007
(73) Proprietor: Koninklijke Philips Electronics N.V., 5621 BA Eindhoven (NL)
(72) Inventor: WEISS, Steffen, NL-5621 BA Eindhoven (NL); NIELSEN, Tim, NL-5621 BA Eindhoven (NL)
(74) Representative: Cohen, Julius Simon
(86) International application number: PCT/IB2005/051069
(87) International publication number: WO 2005/103747

(56) References cited:
- WO-A-02/086526
- DE-A1- 19 640 463
- US-A1- 2002 116 028
- PATENT ABSTRACTS OF JAPAN vol. 013, no. 546 (C-661), 6 December 1989 (1989-12-06) & JP 01 223943 A (FUJI ELECTRIC CO LTD), 7 September 1989 (1989-09-07)

## Description

The following relates to the magnetic resonance arts. It finds particular application in magnetic resonance imaging using a local receive coil disposed on a catheter or other interventional instrument that is partially inserted into an imaging subject, and will be described with particular reference thereto. However, it also finds application in sensitive electro-optical transducers for converting weak electrical signals into optical signals for magnetic resonance and other applications.

Radio frequency receive coils are advantageously disposed near or inside of a magnetic resonance imaging subject to improve coupling with the magnetic resonance signal produced by a region of interest of that subject. Surface receive coils, for example, are disposed outside the imaging subject near or in contact with the exterior of the region of interest. For still closer coupling with an internal region of interest, the receive coil can be disposed on a catheter, biopsy needle, or other interventional instrument. The portion of the interventional instrument on which the receive coil is disposed is inserted into the imaging subject such that the receive coil is disposed close to, or inside of, the region of interest. Such an arrangement can also be used to provide magnetic resonance imaging visualizations for guiding a surgeon who is performing an interventional procedure using the interventional instrument.

However, problems arise in placing the receive coil close to or inside of the imaging subject. One problem relates to the use of conductive wires to transmit the received magnetic resonance signal to a radio frequency receiver or other signal processing equipment. The conductive wires can inductively heat in the magnetic resonance imaging environment, producing a safety hazard. The conductive wire may also distort radio frequency fields in the imaging subject, producing imaging artifacts.

One approach to addressing these difficulties is to employ a wireless receive coil, in which a transmitter disposed on or near the receive coil shifts the received magnetic resonance signal to another frequency range and transmits the frequency-shifted signal to an external receiver. This approach has disadvantage in that the hardware for performing the heterodyning of the magnetic resonance signal must be disposed on the receive coil. This is difficult in the case of surface coils, and more difficult in the case of a receive coil disposed on a catheter or other interventional instrument. Moreover, the heterodyning circuitry generally requires electrical power typically supplied by electrical power conductors, which again may introduce difficulties such as conductor heating or introduction of imaging artifacts.

Another approach is described in the International Application of inventors Konings and Weiss (WO 02/086526 A1, published Oct. 31, 2002). The disclosed approach employs optical fibers to input linearly polarized light to the receive coil. An electro-optical modulator connected with the coil has crossed polarizers with an electro-optically active material disposed therebetween. The electro-optically active material produces a polarization rotation. The two polarizers are crossed to extinguish the light in the absence of an applied electric field. The radio frequency antenna of the receive coil imposes an oscillating electric field on the electro-optically active material which rotates the polarization, permitting some light to pass through the crossed polarizers. This approach has certain sensitivity difficulties. The crossed polarizers should be arranged to accurately null the light transmission in the absence of an applied electric field, so that the slight change in optical rotation is detectable with adequate dynamic range. This nulling is complicated by Faraday rotation produced by the strong magnetic fields and magnetic field gradients present in the magnetic resonance imaging environment. The amount of Faraday rotation changes with changes in the magnetic field, such as are produced by magnetic field gradient coils. The Faraday rotation competes with and can obscure the electro-optical rotation.

The present invention contemplates an improved apparatus and method that overcomes the aforementioned limitations and others.

According to one aspect, a receive coil for magnetic resonance imaging is disclosed. An optical resonant cavity includes an electro-optically active medium. A radio frequency antenna is coupled with the electro-optically active medium such that reception of a magnetic resonance signal by the radio frequency antenna modulates an optical characteristic of the optical resonant cavity. At least one optical fiber is optically coupled with the optical resonant cavity.

According to another aspect, a method is provided for detecting magnetic resonance. Light is optically coupled with an optical resonant cavity. The optically coupled light is modulated using a radio frequency antenna to produce modulated light. The modulating includes electro-optically modulating an electro-optically active medium of the optical resonant cavity responsive to reception of a magnetic resonance signal by the radio frequency antenna. An optical characteristic of the optical resonant cavity is measured based on the modulated light.

According to yet another aspect, a magnetic resonance imaging scanner is disclosed. A magnet generates a temporally constant magnetic field in an imaging region. One or more magnetic field gradient coils superimpose selected magnetic field gradients on the temporally constant magnetic field in the imaging region. A radio frequency transmitter injects a magnetic resonance excitation signal into the imaging region. A receive coil is provided. An optical resonant cavity includes an electro-optically active medium. A radio frequency antenna is coupled with the electro-optically active medium such that reception of a magnetic resonance signal by the radio frequency antenna modulates an optical characteristic of the optical resonant cavity. An interventional instrument is adapted for partial insertion into an associated imaging subject. The radio frequency antenna and the optical resonant cavity are disposed on a portion of the interventional instrument that is inserted into the associated imaging subject. At least one optical fiber is optically coupled with the optical resonant cavity. An end of the at least one optical fiber extends outside of the associated imaging subject when the interventional instrument is partially inserted.

One advantage resides in providing a safe magnetic resonance receive coil that does not include electrical inputs or outputs.

Another advantage resides in improved sensitivity to the magnetic resonance signal. The sensitivity can be improved by a factor of about 10⁴ to 10⁵ as compared with the polarization rotation-based electro-optic modulator of WO 02/086526 A1 which was discussed in the Background of the Invention.

Yet another advantage resides in reduced or eliminated sensitivity to magnetic field-induced Faraday rotation effects.

Numerous additional advantages and benefits will become apparent to those of ordinary skill in the art upon reading the following detailed description of the preferred embodiments.

The invention may take form in various components and arrangements of components, and in various process operations and arrangements of process operations. The drawings are only for the purpose of illustrating preferred embodiments and are not to be construed as limiting the invention.
FIGURE 1 diagrammatically shows a magnetic resonance imaging system including a magnetic resonance receive coil disposed on a catheter.
FIGURE 2 diagrammatically shows an embodiment of the magnetic resonance receive coil of FIGURE 1.
FIGURE 3 diagrammatically plots a transmission characteristic of the optical resonant cavity of the magnetic resonance receive coil.
FIGURE 4 diagrammatically shows another embodiment of the magnetic resonance receive coil of FIGURE 1.
FIGURE 5 diagrammatically shows yet another embodiment of the magnetic resonance receive coil of FIGURE 1.
FIGURE 6 diagrammatically plots a reflection characteristic of the optical resonant cavity of the magnetic resonance receive coil of FIGURE 5.

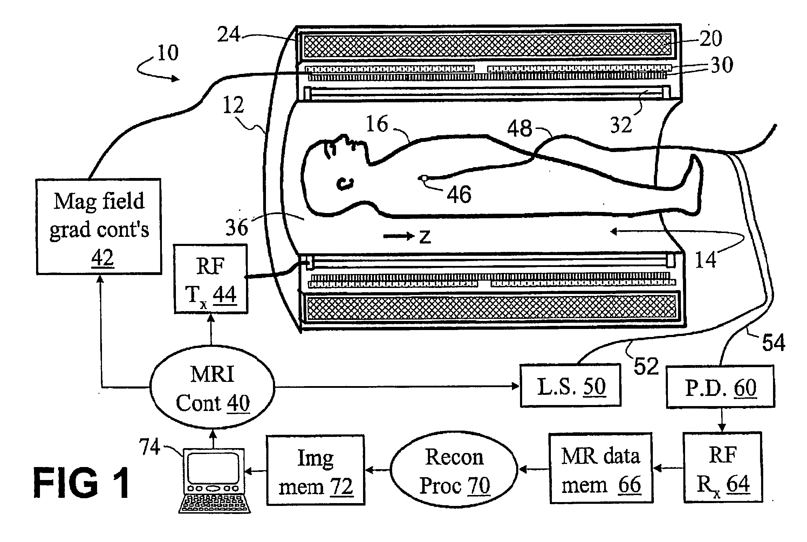

With reference to FIGURE 1, a magnetic resonance imaging scanner **10** includes a housing **12** defining a generally cylindrical scanner bore **14** inside of which an associated imaging subject **16** is disposed. Main magnetic field coils **20** are disposed inside the housing **12,** and produce a temporally constant B₀ magnetic field directed generally along a direction, designated the z-direction in FIGURE 1, which is substantially parallel to a central axis of the scanner bore **14.**

The housing **12** also houses or supports magnetic field gradient-generating structures, such as magnetic field gradient coils **30,** for selectively producing magnetic field gradients parallel to the z-direction, transverse to the z-direction, or along other selected directions. The housing **12** further houses or supports a radio frequency body coil **32** for selectively exciting magnetic resonances. Specifically, the radio frequency body coil **32** produces a radio frequency B₁ magnetic field transverse to the temporally constant B₀ magnetic field. The radio frequency B₁ magnetic field is generated at the Larmor frequency for exciting a nuclear magnetic resonance. In the illustrated embodiment, the coil **32** is a whole body birdcage coil; however, a local coil, a whole-body TEM coil, or other radio frequency coil can be used for exciting magnetic resonance in the subject **16.** The housing **12** typically includes a cosmetic inner liner **36** inside the birdcage coil **32** defining the scanner bore **14.**

During imaging, the main magnetic field coils **20** produce the temporally constant B₀ magnetic field parallel to the z-direction in the bore **14.** A magnetic resonance imaging controller **40** operates magnetic field gradient controllers **42** to selectively energize the magnetic field gradient coils **30,** and operates a radio frequency transmitter **44** coupled to the radio frequency coil **32** to selectively energize the radio frequency coil **32.** By selectively operating the magnetic field gradient coils **30** and the radio frequency coil **32,** magnetic resonance is generated and spatially encoded in at least a portion of a region of interest of the imaging subject **16.** By applying selected magnetic field gradients via the gradient coils **30,** a selected k-space trajectory is traversed during acquisition of magnetic resonance signals, such as a Cartesian trajectory, a plurality of radial trajectories, or a spiral trajectory.

The described magnetic resonance imaging scanner is an example. The magnetic field receive coils described herein can be employed with substantially any type of magnetic resonance imaging scanner, such as an open magnet scanner, a vertical magnet scanner, or so forth. Moreover, the magnetic field receive coils described herein can be employed in magnetic resonance procedures other than imaging, such as in magnetic resonance spectroscopy.

During imaging data acquisition, a radio frequency receive coil **46** disposed on a catheter **48** inserted into the imaging subject **16,** or another coil such as a surface receive coil, is used to acquire magnetic resonance samples. The radio frequency receive coil **46** is optically coupled for extracting the magnetic resonance signal. Specifically, a light source **50,** such as a laser, a lamp, or the like, delivers input light into an input optical fiber **52** that passes through a lumen of the catheter **48** to couple with the receive coil **46.** The receive coil produces electro-optical modulation of the input light at the magnetic resonance frequency to produce a modulated output light. An output optical fiber 54 passes through a lumen of the catheter 48 and couples with a photodetector 60, such as a photodiode, a photomultiplier tube, a spectrometer, or the like. The output of the photodetector 60 corresponds to the magnetic resonance signal. The light source 50 is optionally controlled by the magnetic resonance imaging controller 40 to turn the light source on and off, to control the wavelength to match an operating frequency of the electro-optical modulator, or the like.

In some embodiments, the fibers 52, 54 are the same fiber, and an optical coupler/splitter or other optical component or combination of components is used to couple the input light to the fiber and to extract modulated light from the fiber. Still further, in some embodiments the catheter 48 is replaced by a biopsy needle or other interventional instrument. Optionally, the catheter 48 or other interventional instrument also includes hardware for performing an interventional medical procedure, such as hardware for performing balloon angioplasty, and the magnetic resonance imaging employing the radio frequency receive coil 46 is used for image-based surgical guidance. As yet another option, the receive coil can be inserted into the patient and the insertion/removal tools are removed to a remote location during imaging.

In some embodiments, the photodetector 60 produces a radio frequency signal corresponding to an amplitude or intensity of the magnetic resonance signal. The radio frequency electrical signal is demodulated by a radio frequency receiver 64, which is typically a digital receiver although an analog receiver can also be used, to produce magnetic resonance data that are stored in a magnetic resonance data memory 66. The magnetic resonance data are reconstructed by a reconstruction processor 70 into a reconstructed image. In the case ofk-space sampling data, a Fourier transform-based reconstruction algorithm can be employed. Other reconstruction algorithms, such as a filtered backprojection-based reconstruction, can also be used depending upon the format of the acquired magnetic resonance imaging data. The reconstructed image generated by the reconstruction processor 70 is stored in an image memory 72, and can be displayed on a user interface 74, stored in non-volatile memory, transmitted over a local intranet or the Internet, viewed, stored, manipulated, or so forth. The user interface 74 can also enable a radiologist, technician, or other operator of the magnetic resonance imaging scanner 10 to communicate with the magnetic resonance imaging controller **40** to select, modify, and execute magnetic resonance imaging sequences.

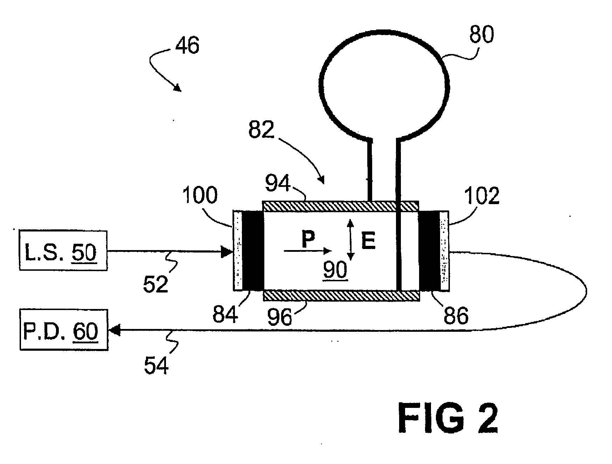

With reference to FIGURE 2, in one embodiment the receive coil 46 includes a radio frequency receive antenna **80** tuned to detect the magnetic resonance. The antenna **80** is coupled with an optical resonant cavity **82** including mirrors **84, 86** that define a length of the resonant cavity. The optical resonant cavity **82** includes an electro-optically active medium **90** disposed between the mirrors **84, 86.**

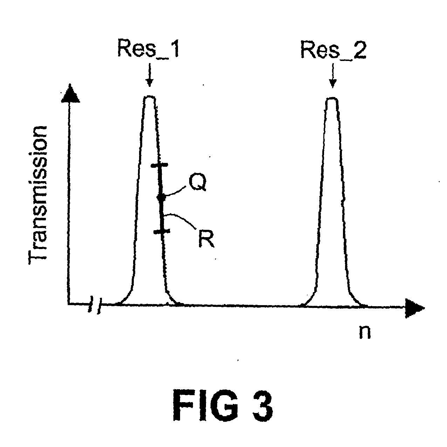

With continuing reference to FIGURE 2 and with brief reference to FIGURE 3, the optical resonant cavity **82** including the mirrors **84, 86** and the electro-optically active medium **90** define a Fabry-Perot resonator whose resonance frequencies depend upon the refractive index ("n") of the electro-optically active medium **90.** For example, as plotted in FIGURE 3, a transmission characteristic of the optical resonant cavity **82** for a particular wavelength varies as a function of the refractive index of the electro-optically active medium **90** seen by the propagating light. Certain refractive index values correspond to a resonance condition for that particular wavelength, and at such a resonance condition the transmission of the optical resonant cavity **82** becomes large. In some embodiments, the transmission approaches unity at resonance. In FIGURE 3, two such resonance conditions are indicated as "Res_1" and "Res_2". On the other hand, for refractive index values substantially different from a resonance condition, the transmission of the optical resonant cavity **82** becomes small. In some embodiments, the transmission approaches zero away from a resonance condition.

With continuing reference to FIGURE 2, the light source **50** injects light into the optical resonant cavity **82.** The injected light couples into the optical resonant cavity **82** and passes through the electro-optically active medium **90** in a propagation direction **P.** Preferably, the electro-optically active medium **90** is transparent or substantially light transmissive for light produced by the light source **50.** The antenna **80** is coupled with the electro-optically active medium **90** through electrodes **94, 96** arranged relative to the optical resonant cavity **82** so as to produce an electric field **E** directed transverse to the propagation direction **P** of the light. The electric field **E** modifies the refractive index of the electro-optically active medium **90.** The injected light is preferably polarized in the direction of the electric field E by an input polarizer **100** so as to maximize the refractive index modulation seen by the propagating light.

With continuing reference to FIGURE 2 and with returning reference to FIGURE 3, in one embodiment the light source **50** produces a substantially monochromatic light for which the transmission characteristic of the optical resonant cavity **82** is plotted in FIGURE 3. For example, the light source **50** can be a monochromatic laser, or it can be a broad-band lamp with suitable narrow band-pass filtering to derive substantially monochromatic light. The optical resonant cavity **82** is tuned to a quiescent operating point **Q** in the absence of an electric field **E** applied by the antenna **80.** The quiescent operating point **Q** corresponds to a slightly off-resonance condition in which the transmissivity slope as a function of refractive index is large.

When the antenna **80** receives a magnetic resonance signal, it develops an induced oscillating voltage that in turn produces the electric field **E** in the electro-optically active medium **90** which oscillates at the magnetic resonance frequency. The oscillating electric field **E** produces a corresponding oscillating refractive index value of the electro-optically active medium **90** which causes the transmission characteristic of the optical resonant cavity **82** to oscillate about the quiescent operating point **Q** over a range **R** indicated in FIGURE 3.

In some embodiments, the light source **50** is monochromatic, and the photodetector **60** measures the amplitude or intensity of the light produced by the light source **50** that is transmitted through and modulated by the optical resonant cavity **82.** This amplitude or intensity has an oscillating variation corresponding to the oscillating electric field **E** caused by the magnetic resonance signal. The background d.c. output of the photodetector **60** is suitably removed by band-pass or high-pass filtering, leaving a radio frequency signal corresponding to the magnetic resonance signal.

In other embodiments, the light source **50** is a relatively broad-band light source producing polychromatic light over a selected wavelength range. The optical resonant cavity **82** acts as a narrow-band filter passing the resonant wavelength. As the oscillating electric field **E** oscillates the refractive index value of the electro-optically active medium **90,** the resonant frequency correspondingly oscillates. In these embodiments, the photodetector **60** is a spectrometer, and the wavelength shift of the resonance condition caused by the applied electric field **E** and measured by the spectrometer corresponds to the magnetic resonance signal intensity.

While the described embodiments operate based on electro-optical changes in refractive index, it is also contemplated to modulate the light by electrically changing the absorption properties of the active medium via the electro-absorption or Franz-Keldysh effect. For active media exhibiting a substantial electro-absorption, it may be possible to omit the optical resonant cavity **82.**

The radio frequency receive coil **46** operates inside the bore **14** of the magnetic resonance imaging scanner **10.** This environment includes large magnetic fields and magnetic field gradients, which can induce Faraday rotation in light propagating through the electro-optically active medium **90,** and perhaps also in the light passing through the optical fiber **52.** In some embodiments, the light source **50** produces circularly polarized light, which is unaffected by any Faraday rotation which occurs during light transmission through the input optical fiber **52.** The input linear polarizer **100** is preferably disposed close to the optical resonant cavity **82** to further reduce extraneous Faraday rotation effects. Optionally, a second, output polarizer **102** disposed at the output of the optical resonant cavity **82** substantially removes depolarized or scattered light to improve the signal-to-noise ratio.

The radio frequency receive coil **46** can be constructed in various ways. The antenna **80** is suitably a printed circuit, conductive coil, or other receive antenna such as are typically used to instrument catheters, biopsy needles, other interventional instruments, or other local coils. In one embodiment the optical resonant cavity **82** is an optical fiber portion made of quartz, KH₂PO₄ (KDP), beta barium borate (BBO), or another electro-optically active material, with the electrodes **94, 96** evaporated on the outside of the optical fiber. These KDP, BBO, and certain other electro-optical materials are suitable for operation in the visible or near-infrared wavelength range.

In another embodiment, the optical resonant cavity **82** is embodied as a thin film or chip of KDP, BBO, or another electro-optically active material with the electrodes **94, 96** and mirrors **84, 86** evaporated or otherwise deposited thereon. In yet another embodiment, a GaAs/AlGaAs resonant cavity is employed, in which the mirrors **84, 86** are distributed Bragg reflectors (DBR's) defined by stacks of alternating GaAs and AlGaAs layers or by stacks of alternating layers of AlGaAs of different aluminum compositions. GaAs-based resonant cavities are typically tuned to an infra-red wavelength or a visible wavelength preferably in the red range. Other heteroepitaxial semiconductor-based resonant cavity structures can also be employed, such as, for example, a group III-phosphide resonant cavity structure.

A reduced separation of the electrodes **94, 96** such as is provided by a thin film advantageously produces large electric fields **E.** However, the separation of the electrodes **94, 96** should be large enough so that the optical resonant cavity **82** has good light coupling and throughput, at least commensurate with the transmission fibers **52**, **54.** Those skilled in the art can readily select dimensions that advantageously balance these considerations in specific embodiments.

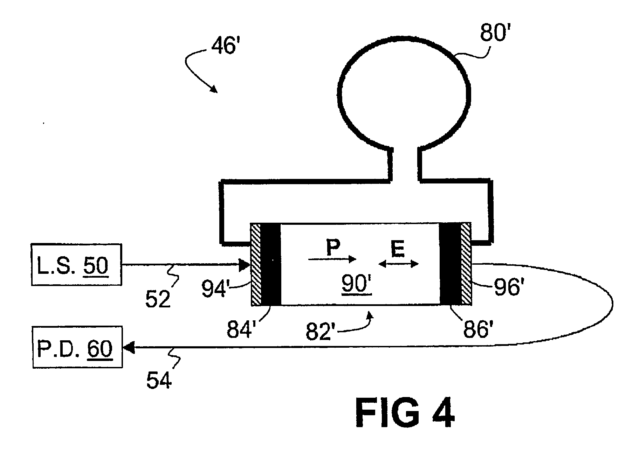

With reference to FIGURE 4, another embodiment of the radio frequency receive coil **46'** includes a radio frequency antenna **80'** coupled with a resonant cavity **82'** having a cavity length defined by mirrors **84', 86'** and including an electro-optically active medium **90'** disposed between the mirrors **84', 86'**. These elements are similar to the corresponding elements of the receive coil **46** of FIGURE 2, and light propagates in a propagation direction **P** in the optical resonant cavity as in the receive coil **46.**

The receive coil **46'** differs from the receive coil **46** in that the receive coil **46'** includes electrodes **94', 96'** disposed on the same sides of the optical resonant cavity **46'** as the mirrors **84', 86'** to produce an electric field **E** directed along the propagation direction **P,** rather than transverse to the propagation direction **P** as in the receive coil **46.** While separate mirrors **84', 86'** and electrodes **94', 96'** are illustrated, in some embodiments the mirrors may also serve as electrodes. If the electrodes **94', 96'** are distinct from the mirrors **84', 86',** then the electrodes **94', 96'** should be substantially transparent to light produced by the light source **50.** For example, thin indium tin oxide (ITO) electrodes can be employed.

Since in the optical resonant cavity **82'** the electric field **E** is parallel with and directed along the propagation direction **P,** modulation of the refractive index of the electro-optically active medium **90'** produced by the magnetic resonance signal causes the transmission characteristic of the optical resonant cavity **82'** to oscillate for any polarization of the propagating light. Hence, no polarizer is needed, and moreover the radio frequency receive coil **46'** is insensitive to Faraday rotation. Because the electric field **E** is produced by applying the induced voltage of the coil **80**' across the length of the optical resonant cavity **82',** the cavity length is selected based on competing considerations of (i) providing a relatively long cavity so that the cavity has a large quality factor and reduced capacitance, and (ii) providing a relatively short cavity so that the oscillating electric field **E** has a large enough amplitude or intensity to produce a substantial electro-optic effect. A cavity length of about 3-5 millimeters is suitable for some embodiments operating in the visible or near-infrared.

The receive coil **46'** is operated similarly to the operation of the receive coil **46.** In one embodiment, the light source **50** is monochromatic, and the optical resonant cavity **82'** has a quiescent operating point selected to provide a large transmission slope as a function of refractive index. Modulation produced by the magnetic resonance signal received by the antenna **80'** modulates the refractive index of the electro-optically active medium **90'** which in turn modulates the intensity of the transmitted monochromatic light. The photodetector **60** detects the amplitude or intensity of the modulated transmitted monochromatic light, and the radio frequency component of the output of the photodetector **60** is recovered by suitable filtering. Alternatively, the light source **50** is polychromatic, the photodetector **60** is a spectrometer, and the magnetic resonance signal is determined based on the wavelength shift produced by shifting of the resonance wavelength of the optical resonant cavity **82'** caused by the oscillating electric field **E**.

In both receive coils **46, 46',** an optical transmission characteristic of the optical resonant cavity **82, 82'** is measured to determine the magnetic resonance signal.

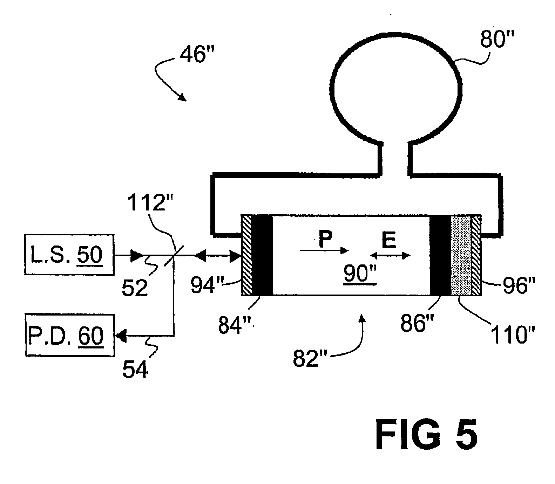

With reference to FIGURE 5, still yet other embodiments of the radio frequency receive coil **46"** employ a reflection geometry. The receive coil **46"** includes a radio frequency antenna **80"** coupled with a resonant cavity **82"** having a cavity length defined by mirrors **84", 86"** and including an electro-optically active medium **90"** disposed between the mirrors **84", 86".** Electrodes **94", 96"** are disposed on the same sides of the optical resonant cavity **82"** as the mirrors **84", 86"** to produce an electric field **E** directed along the light propagation direction **P.** These elements of the receive coil **46"** are similar to the corresponding elements of the receive coil **46'** of FIGURE 4.

The receive coil **46"** differs from the receive coil **46'** in that the optical resonant cavity **82"** includes a light-absorbing region **110"** that absorbs light produced by the light source **50.** Moreover, the optical geometry is different. Rather than measuring a transmission characteristic, the receive coil **46"** includes an optical coupler/decoupler, such as a beam splitter **112".** Light is coupled from the light source **50** to the optical resonant cavity **82"** via an optical fiber. Light reflected from the optical resonant cavity **82"** reflects back into the optical fiber and propagates back to the beam splitter **112",** which diverts at least a portion of the reflected light to the photodetector **60.**

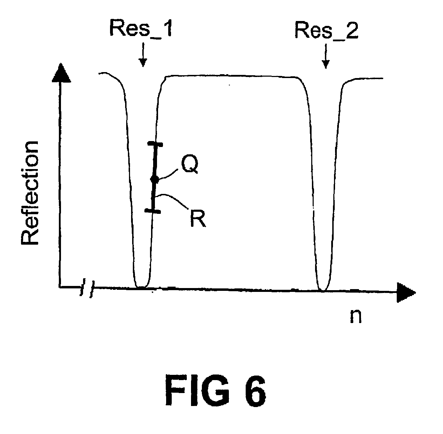

With continuing reference to FIGURE 5 and with further reference to FIGURE 6, in one embodiment the light source **50** produces a substantially monochromatic light for which the reflection characteristic of the optical resonant cavity **82"** is plotted in FIGURE 6. When the refractive index value of the electro-optically active medium **90"** is such that the light is away from resonance, then the optical resonant cavity **82"** is not optically transmissive, but rather is optically reflective. Thus, the reflection characteristic is large off resonance. However, when the refractive index value of the electro-optically active medium **90"** is such that the light is at a resonance condition, the light enters the resonant cavity **82"** and passes through the cavity. However, the light transmitted through the optical resonant cavity **82"** is substantially absorbed by the light-absorbing region **110".** Hence, when the refractive index value tunes the cavity to resonate with the monochromatic light, the light is substantially absorbed in light-absorbing region **110"** and the reflection characteristic decreases. In some embodiments, the reflectivity is about unity off resonance, and decreases to about zero at a resonant condition. In FIGURE 6, two illustrated resonant conditions are labeled "Res_1" and Res_2".

When the antenna 80" receives a magnetic resonance signal, it develops an induced radio frequency voltage producing the oscillating electric field **E**, which in turn produces an oscillating refractive index value of the electro-optically active medium **90** which causes the reflection characteristic of the optical resonant cavity **82** to oscillate about a quiescent operating point **Q** over a range **R** indicated in FIGURE 6. The quiescent operating point **Q** is selected to correspond to a region in which the slope of the reflectivity as a function of refractive index is large. The photodetector **60** measures the amplitude or intensity of the light produced by the light source **50** that is reflected by the optical resonant cavity **82.** This amplitude or intensity has an oscillating variation corresponding to the oscillating electric field **E** caused by the magnetic resonance signal. The background d.c. output of the photodetector **60** is suitably removed by band-pass or high-pass filtering, leaving a radio frequency signal corresponding to the magnetic resonance signal.

The described magnetic resonance receive coils **46, 46', 46"** are suitable for mounting on or inside of an interventional instrument, such as the example catheter **48.** A portion of the interventional instrument is inserted into the imaging subject **16** to place the magnetic resonance receive coil 46, 46', 46" close to the region of interest. Optionally, the imaging is performed during an interventional surgical procedure to provide the surgeon with visual guidance while performing the surgical.procedure.

It will be appreciated that the magnetic resonance receive coils 46, 46', 46" can be used in other settings besides on or in an interventional instrument. For example, those skilled in the art can readily construct a wireless surface receive coil, an array of wireless receive coils, or the like which employ the electro-optical modulation techniques of the described magnetic resonance receive coils 46, 46', 46".

## Claims

1. A receive apparatus for converting electromagnetic signals to optical signals or detecting magnetic resonance signals, the receive apparatus comprising an electro-optical modulator, a radio frequency antenna (80, 80', 80") coupled with the electro-optical modulator, at least one optical fiber (52, 54) optically coupled with the electro-optical modulator, **characterized in that** the electro-optical modulator comprises an optical resonant cavity (82, 82', 82") including an electro-optically active medium (90, 90', 90"), wherein the radio frequency antenna (80, 80', 80") is coupled with the electro-optically active medium such that reception of a magnetic resonance signal by the radio frequency antenna modulates an optical characteristic of the optical resonant cavity.

2. The receive apparatus as set forth in claim 1, **characterized in that** the radio frequency antenna (80, 80', 80") and the optical resonant cavity (82, 82', 82") are disposed on or in a portion of an interventional instrument (48) adapted for partial insertion into an associated imaging subject (16), an end of the at least one optical fiber (52, 54) extending outside of the associated imaging subject.

3. The receive apparatus as set forth in claim 2, **characterized by** electrodes (94, 96) coupled with the radio frequency antenna (80), the electrodes arranged to produce an electric field in the electro-optically active medium (90) directed transverse to a direction of light transmission through the optically resonant cavity (82).

4. The receive apparatus as set forth in claim 3, **characterized by** a light source (50) producing circularly polarized light inputted to the at least one optical fiber (52), and a polarizer (100) disposed between the at least one optical fiber (52) and the optical resonant cavity (82), the polarizer converting the circularly polarized light into linearly polarized light.

5. The receive apparatus as set forth in claim 2, **characterized by** electrodes (94', 94", 96', 96") coupled with the radio frequency antenna (80', 80"), the electrodes arranged to produce an electric field in the electro-optically active medium (90', 90") directed parallel with a direction of light propagation in the optically resonant cavity (82', 82").

6. The receive apparatus as set forth in claim 2, **characterized by** a substantially monochromatic light source (50) producing substantially monochromatic light inputted to the at least one optical fiber (52), and a photodetector (60) arranged to detect an amplitude or intensity of the inputted substantially monochromatic light after interacting with the optical resonant cavity (82', 82").

7. The receive apparatus as set forth in claim 2, **characterized by** a light source (50) producing polychromatic light spanning a band of wavelengths inputted to the at least one optical fiber (52), and a spectrometer arranged to measure a spectrum of the inputted light after interacting with the optical resonant cavity (82', 82").

8. The receive apparatus as set forth in claim 5, **characterized in that** the at least one optical fiber (52, 54) includes:
an input optical fiber (52) that injects light into an input side of the optical resonant cavity (82'); and
an output optical fiber (54) that receives light passing out of an output side of the optical resonant cavity (82') opposite the input side.

9. The receive apparatus as set forth in claim 5, **characterized by** a light-absorbing region (110") disposed behind the optical resonant cavity (82") that absorbs light transmitted through the optical resonant cavity.

10. The receive apparatus as set forth in claim 5, **characterized in that** the electrodes (94', 94", 96', 96") additionally serve as mirrors of the optical resonant cavity (82', 82").

11. The receive apparatus as set forth in claim 1, **characterized by** electrodes (94, 96) coupled with the radio frequency antenna (80), the electrodes arranged to produce an electric field in the electro-optically active medium (90) directed transverse to a direction of light transmission through the optical resonant cavity (82), and a polarizer (100) disposed between the at least one optical fiber (52) and the optical resonant cavity (82), the polarizer converting the circularly polarized light into linearly polarized light.

12. The receive apparatus as set forth in claim 1, **characterized by** electrodes (94', '96') coupled with the radio frequency antenna (80'), the electrodes arranged to produce an electric field in the electro-optically active medium (90') directed parallel with a direction of light transmission through in the optical resonant cavity (82'), an input optical fiber (52) that injects light into an input side of the optical resonant cavity (82'), and an output optical fiber (54) that receives light passing out of an output side of the optically resonant cavity (82') opposite the input side.

13. The receive apparatus as set forth in claim 1, **characterized by** electrodes (94", 96") coupled with the radio frequency antenna (80"), the electrodes arranged to produce an electric field in the electro-optically active medium (90") directed parallel with a direction of light propagation in the optical resonant cavity (82"), an absorption region (110") disposed behind the optically resonant cavity (82") that absorbs light transmitted through the optical resonant cavity, and an optical coupler (112") coupling an input light into the at least one fiber (52) and extracting reflected light reflected from the optically resonant cavity (82") from the at least one fiber.

14. The receive apparatus as set forth in claim 1, **characterized in that** the modulated optical characteristic is selected from a group consisting of refractive index and absorption.

15. A method for detecting a magnetic resonance signal, the method comprising optically coupling light with an electro-optical modulator and modulating the optically coupled light using a radio frequency antenna (80, 80', 80") to produce modulated light, **characterized in that** the electro-optical modulator comprises an optical resonant cavity (82, 82', 82"), wherein the modulating includes electro-optically modulating an electro-optically active medium (90, 90', 90") of the optical resonant cavity responsive to reception of the magnetic resonance signal by the radio frequency antenna, the method further comprising measuring an optical characteristic of the optical resonant cavity based on the modulated light.

16. The method as set forth in claim 15, **characterized in that** the radio frequency antenna (80, 80', 80") and the optical resonant cavity (82, 82', 82") are disposed on or in an interventional instrument (48), the method further comprising inserting a portion of the interventional instrument (48) having the radio frequency antenna (80, 80', 80") and the optical resonant cavity (82, 82', 82") disposed thereon or therein into an associated imaging subject (16), an optical fiber (52, 54) extending outside the imaging subject when the interventional instrument is inserted providing optical access to the optical resonant cavity.

17. The method as set forth in claim 15, **characterized in that** the modulating comprises producing an electric field transverse to a direction of light propagation in the optical resonant cavity (82).

18. The method as set forth in claim 17, **characterized in that** the optical coupling of light comprises linearly polarizing light, the linearly polarized light being optically coupled with the optical resonant cavity (82).

19. The method as set forth in claim 15, **characterized in that** the modulating comprises producing an electric field along a direction of light propagation in the optical resonant cavity (82', 82").

20. The method as set forth in claim 19, **characterized in that** the measuring of an optical characteristic of the optical resonant cavity comprises measuring an optical transmission characteristic of the optical resonant cavity (82').

21. The method as set forth in claim 19, **characterized in that** the measuring of an optical characteristic of the optical resonant cavity comprises absorbing at least a portion of light behind the optical resonant cavity (82"), and measuring an optical reflection characteristic of the optical resonant cavity.

22. A magnetic resonance imaging scanner comprising:
a magnet (20) generating a temporally constant magnetic field in an imaging region;
one or more magnetic field gradient coils (30) superimposing selected magnetic field gradients on the temporally constant magnetic field in the imaging region;
a radio frequency transmitter (32, 44) injecting a magnetic resonance excitation signal into the imaging region,
**characterized by**
a receive apparatus (46, 46', 46") comprising:
an optical resonant cavity (82, 82', 82") including an electro-optically active medium (90, 90', 90"),
a radio frequency antenna (80, 80', 80") coupled with the electro-optically active medium such that reception of a magnetic resonance signal by the radio frequency antenna modulates an optical characteristic of the optical resonant cavity,
an interventional instrument (48) adapted for partial insertion into an associated imaging subject (16), the radio frequency antenna and the optical resonant cavity being disposed on a portion of the interventional instrument that is inserted into the associated imaging subject, and
at least one optical fiber (52, 54) optically coupling with the optical resonant cavity, an end of the at least one optical fiber extending outside of the associated imaging subject when the interventional instrument is partially inserted.

## Patentansprüche

1. Empfangsgerät zum Umwandeln elektromagnetischer Signale in optische Signale oder zum Detektieren von Resonanzsignalen, wobei das Empfangsgerät einen elektrooptischen Modulator, eine mit dem elektrooptischen Modulator gekoppelte Hochfrequenzantenne (80, 80', 80") und mindestens eine mit dem elektrooptischen Modulator optisch gekoppelte optische Faser (52, 54) umfasst, **dadurch gekennzeichnet, dass** der elektrooptische Modulator einen optischen Hohlraumresonator (82, 82', 82") mit einem elektrooptisch aktiven Medium (90, 90', 90") umfasst, wobei die Hochfrequenzantenne (80, 80', 80") dergestalt mit dem elektrooptisch aktiven Medium gekoppelt ist, dass der Empfang eines Magnetresonanzsignals durch die Hochfrequenzantenne eine optische Eigenschaft des optischen Hohlraumresonators moduliert.

2. Empfangsgerät nach Anspruch 1, **dadurch gekennzeichnet, dass** die Hochfrequenzantenne (0, 80', 80") und der optische Hohlraumresonator (82, 82', 82") auf oder in einem Teil eines interventionellen Instruments (48) angeordnet sind, das zum partiellen Einführen in ein zugehöriges Bildgebungsobjekt (16) vorgesehen ist, wobei ein Ende der mindestens einen optischen Faser (52, 54) aus dem zugehörigen Bildgebungsobjekt herausreicht.

3. Empfangsgerät nach Anspruch 2, **gekennzeichnet durch** mit der Hochfrequenzantenne (80) gekoppelte Elektroden (94, 96), wobei die Elektroden vorgesehen sind, um ein elektrisches Feld in dem elektrooptisch aktiven Medium (90) zu erzeugen, das quer zu einer Richtung der Lichtübertragung **durch** den optischen Hohlraumresonator (82) ausgerichtet ist.

4. Empfangsgerät nach Anspruch 3, **gekennzeichnet durch** eine Lichtquelle (50), die kreisförmig polarisiertes Licht erzeugt, welches in die mindestens eine optische Faser (52) eingespeist wird, und einen zwischen der mindestens einen optischen Faser (52) und dem optischen Hohlraumresonator (82) angeordneten Polarisator (100), wobei der Polarisator das kreisförmig polarisierte Licht in linear polarisiertes Licht umwandelt.

5. Empfangsgerät nach Anspruch 2, **gekennzeichnet durch** mit der Hochfrequenzantenne (80', 80") gekoppelte Elektroden (94', 94", 96', 96"), wobei die Elektroden vorgesehen sind, um ein elektrisches Feld in dem elektrooptisch aktiven Medium (90', 90") zu erzeugen, das parallel zu einer Richtung der Lichtausbreitung in dem optischen Hohlraumresonator (82', 82") ausgerichtet ist.

6. Empfangsgerät nach Anspruch 2, **gekennzeichnet durch** eine im Wesentlichen monochromatische Lichtquelle (50), die im Wesentlichen monochromatisches Licht erzeugt, welches in die mindestens eine optische Faser (52) eingespeist wird, und einen Photodetektor (600), der vorgesehen ist, um eine Amplitude oder Intensität des eingespeisten im Wesentlichen monochromatischen Lichts nach dem Interagieren mit dem optischen Hohlraumresonator (82', 82") zu detektieren.

7. Empfangsgerät nach Anspruch 2, **gekennzeichnet durch** eine Lichtquelle (50), die polychromatisches, ein Wellenlängenband überspannendes Licht erzeugt, das in die mindestens eine optische Faser (52) eingespeist wird, und ein Spektrometer, das vorgesehen ist, um ein Spektrum des eingespeisten Lichts nach dem Interagieren mit dem optischen Hohlraumresonator (82', 82") zu messen.

8. Empfangsgerät nach Anspruch 5, **dadurch gekennzeichnet, dass** die mindestens eine optische Faser (52, 54) Folgendes umfasst:
eine optische Eingangsfaser (52), die Licht in eine Eingangsseite des optischen Hohlraumresonators (82') injiziert; und
eine optische Ausgangsfaser (54), die Licht empfängt, das aus einer der Eingangsseite gegenüberliegenden Ausgangsseite des optischen Hohlraumresonators (82') austritt.

9. Empfangsgerät nach Anspruch 5, **gekennzeichnet durch** eine Licht absorbierende Region (110"), die hinter dem optischen Hohlraumresonator (82") angeordnet ist und das **durch** den optischen Hohlraumresonator übertragene Licht absorbiert.

10. Empfangsgerät nach Anspruch 5, **dadurch gekennzeichnet, dass** die Elektroden (94', 94", 96', 96") zusätzlich als Spiegel des optischen Hohlraumresonators (82', 82") dienen.

11. Empfangsgerät nach Anspruch 1, **gekennzeichnet durch** mit der Hochfrequenzantenne (80) gekoppelte Elektroden (94, 96), wobei die Elektroden vorgesehen sind, um ein elektrisches Feld in dem elektrooptisch aktiven Medium (90) zu erzeugen, das quer zu einer Richtung der Lichtübertragung **durch** den optischen Hohlraumresonator (82) ausgerichtet ist, und einen Polarisator (100), der zwischen der mindestens einen optischen Faser (52) und dem optischen Hohlraumresonator (82) angeordnet ist, wobei der Polarisator das kreisförmig polarisierte Licht in linear polarisiertes Licht umwandelt.

12. Empfangsgerät nach Anspruch 1, **gekennzeichnet durch** mit der Hochfrequenzantenne (80') gekoppelte Elektroden (94', 96'), wobei die Elektroden vorgesehen sind, um ein elektrisches Feld in dem elektrooptisch aktiven Medium (90') zu erzeugen, das parallel zu einer Richtung der Lichtübertragung **durch** den optischen Hohlraumresonator (82') ausgerichtet ist, eine optische Eingangsfaser (52), die Licht in eine Eingangsseite des optischen Hohlraumresonators (82') injiziert, und eine optische Ausgangsfaser (54), die aus einer der Eingangsseite gegenüberliegenden Ausgangsseite des optischen Hohlraumresonator (82') austretendes Licht empfängt.

13. Empfangsgerät nach Anspruch 1, **gekennzeichnet durch** mit der Hochfrequenzantenne (80") gekoppelte Elektroden (94", 96"), wobei die Elektroden vorgesehen sind, um ein elektrisches Feld in dem elektrooptisch aktiven Medium (90") zu erzeugen, das parallel zu einer Richtung der Lichtausbreitung in dem optischen Hohlraumresonator (82") ausgerichtet ist, wobei eine Absorptionsregion (110") hinter dem optischen Hohlraumresonator (82") angeordnet ist, die **durch** den optischen Hohlraumresonator übertragenes Licht absorbiert, und einen Optokoppler (112') zum Einkoppeln eines Eintrittslichts in die mindestens eine Faser (52) und zu Extrahieren von reflektiertem Licht, das von dem optischen Hohlraumresonator (82") reflektiert wurde, aus der mindestens einen Faser.

14. Empfangsgerät nach Anspruch 1, **dadurch gekennzeichnet, dass** die modulierte optische Eigenschaft aus einer Gruppe bestehend aus Brechungsindex und Absorption ausgewählt wird.

15. Verfahren zum Detektieren eines Magnetresonanzsignals, wobei das Verfahren das optische Koppeln von Licht mit einem elektrooptischen Modulator und das Modulieren des optisch gekoppelten Lichts mit Hilfe einer Hochfrequenzantenne (80, 80', 80") umfasst, um moduliertes Licht zu erzeugen, **dadurch gekennzeichnet, dass** der elektrooptische Modulator einen optischen Hohlraumresonator (82, 82', 82") umfasst, wobei das Modulieren das elektrooptische Modulieren eines elektrooptisch aktiven Mediums (90, 90', 90") des optischen Hohlraumresonators in Reaktion auf den Empfang des Magnetresonanzsignals durch die Hochfrequenzantenne umfasst, wobei das Verfahren weiterhin das Messen einer optischen Eigenschaft des optischen Hohlraumresonators basierend auf dem modulierten Licht umfasst.

16. Verfahren nach Anspruch 15, **dadurch gekennzeichnet, dass** die Hochfrequenzantenne (80, 80', 80") und der optische Hohlraumresonator (82, 82', 82") auf oder in einem interventionellen Instrument (48) angeordnet sind, wobei das Verfahren weiterhin das Einführen eines Teils des interventionellen Instruments (48) mit darauf oder darin angeordneter Hochfrequenzantenne (80, 80', 80") und optischem Hohlraumresonator (82, 82', 82") in ein zugehöriges Bildgebungsobjekt (16) umfasst, wobei eine optische Faser (52, 54) aus dem Bildgebungsobjekt herausreicht, wenn das interventionelle Instrument eingeführt ist, und optischen Zugang zu dem optischen Hohlraumresonator bietet.

17. Verfahren nach Anspruch 15, **dadurch gekennzeichnet, dass** das Modulieren das Erzeugen eines elektrischen Feldes quer zu einer Richtung der Lichtausbreitung in dem optischen Hohlraumresonator (82) umfasst.

18. Verfahren nach Anspruch 17, **dadurch gekennzeichnet, dass** das optischen Koppeln von Licht das lineare Polarisieren von Licht umfasst, wobei das linear polarisierte Licht optisch mit dem optischen Hohlraumresonator (82) gekoppelt wird.

19. Verfahren nach Anspruch 15, **dadurch gekennzeichnet, dass** das Modulieren das Erzeugen eines elektrischen Feldes entlang einer Richtung der Lichtausbreitung in dem optischen Hohlraumresonator (82', 82") umfasst.

20. Verfahren nach Anspruch 19, **dadurch gekennzeichnet, dass** das Messen einer optischen Eigenschaft des optischen Hohlraumresonators das Messen einer optischen Übertragungseigenschaft des optischen Hohlraumresonators (82') umfasst.

21. Verfahren nach Anspruch 19, **dadurch gekennzeichnet, dass** das Messen einer optischen Eigenschaft des optischen Hohlraumresonators das Absorbieren von mindestens einem Teil des Lichts hinter dem optischen Hohlraumresonator (82") umfasst, und das Messen einer optischen Reflexionseigenschaft des optischen Hohlraumresonators.

22. Magnetresonanzbildgebungsscanner, der Folgendes umfasst:
einen Magneten (20) zum Erzeugen eines zeitlich konstanten Magnetfelds in einer Bildgebungsregion;
eine oder mehrere Magnetfeldgradientenspulen (30), die dem zeitlich konstanten Magnetfeld in der Bildgebungsregion ausgewählte Magnetfeldgradienten überlagert/überlagern;
einen ein Magnetresonanzanregungssignal in die Bildgebungsregion injizierenden Hochfrequenzsender (32, 44),
**gekennzeichnet durch**
ein Empfangsgerät (46, 46', 46"), das Folgendes umfasst:
einen optischen Hohlraumresonator (82, 82', 82") mit einem elektrooptisch aktiven Medium (90, 90', 90"),
eine derartig mit dem elektrooptisch aktiven Medium gekoppelten Hochfrequenzantenne (80, 80', 80"), dass der Empfang eines Magnetresonanzsignals **durch** die Hochfrequenzantenne eine optische Eigenschaft des optischen Hohlraumresonators moduliert,
ein für das partielle Einführen in ein zugehöriges Bildgebungsobjekt (16) vorgesehenes interventionelles Instrument (48), wobei die Hochfrequenzantenne und der optische Hohlraumresonator auf einem Teil des interventionellen Instruments angeordnet sind, welches in das zugehörige Bildgebungssobjekt eingeführt wird, und
mindestens eine optische Faser (52, 54), die optisch mit dem optischen Hohlraumresonator gekoppelt ist, wobei ein Ende der mindestens einen optischen Faser aus dem zugehörigen Bildgebungsobjekt herausreicht, wenn das interventionelle Instrument partiell eingeführt ist.

## Revendications

1. Dispositif récepteur permettant de convertir des signaux électromagnétiques en signaux optiques ou de détecter des signaux de résonance magnétique, ledit dispositif récepteur comprenant un modulateur électro-optique, une antenne à haute fréquence (80, 80', 80") couplée au modulateur électro-optique, au moins une fibre optique (52, 54) couplée optiquement au modulateur électro-optique, **caractérisé en ce que** le modulateur électro-optique comprend une cavité résonante optique (82, 82', 82") comprenant un milieu électro-optiquement actif (90, 90', 90"), l'antenne à haute fréquence (80, 80', 80") étant couplée au milieu électro-optiquement actif de telle façon que la réception d'un signal de résonance magnétique par l'antenne à haute fréquence module une caractéristique optique de la cavité résonante optique.

2. Dispositif récepteur selon la revendication 1, **caractérisé en ce que** l'antenne à haute fréquence (80, 80', 80") et la cavité résonante optique (82, 82', 82") sont disposées sur ou dans une partie d'un instrument d'intervention (48) adapté pour être partiellement introduit dans un sujet d'imagerie associé (16), une extrémité de ladite au moins une fibre optique (52, 54) s'étendant à l'extérieur dudit sujet d'imagerie associé.

3. Dispositif récepteur selon la revendication 2, **caractérisé par** des électrodes (94, 96) couplées à l'antenne à haute fréquence (80), lesdites électrodes étant agencées de façon à générer dans le milieu électro-optiquement actif (90) un champ électrique orienté dans le sens transversal par rapport à une direction de transmission de la lumière à travers la cavité résonante optique (82).

4. Dispositif récepteur selon la revendication 3, **caractérisé par** une source lumineuse (50) produisant de la lumière polarisée circulairement qui est injectée dans ladite au moins une fibre optique (52) et par un polarisateur (100) disposé entre ladite au moins une fibre optique (52) et la cavité résonante optique (82), le polarisateur convertissant la lumière polarisée circulairement en lumière polarisée linéairement.

5. Dispositif récepteur selon la revendication 2, **caractérisé par** des électrodes (94', 94", 96', 96") couplées à l'antenne à haute fréquence (80', 80"), lesdites électrodes étant agencées de façon à générer dans le milieu électro-optiquement actif (90', 90") un champ électrique orienté parallèlement à une direction de propagation de la lumière dans la cavité résonante optique (82', 82").

6. Dispositif récepteur selon la revendication 2, **caractérisé par** une source lumineuse pratiquement monochromatique (50) produisant de la lumière pratiquement monochromatique qui est injectée dans ladite au moins une fibre optique (52), et par un photodétecteur (60) agencé de façon à détecter une amplitude ou une intensité de la lumière pratiquement monochromatique injectée après qu'elle a interagi avec la cavité résonante optique (82', 82").

7. Dispositif récepteur selon la revendication 2, **caractérisé par** une source lumineuse (50) produisant de la lumière polychromatique couvrant une bande de longueurs d'onde qui est injectée dans ladite au moins une fibre optique (52), et par un spectromètre agencé pour mesurer un spectre de la lumière injectée après qu'elle a interagi avec la cavité résonante optique (82', 82").

8. Dispositif récepteur selon la revendication 5, **caractérisé en ce que** ladite au moins une fibre optique (52, 54) comprend :
une fibre optique d'entrée (52) qui injecte de la lumière dans un côté d'entrée de la cavité résonante optique (82') ; et
une fibre optique de sortie (54) qui reçoit la lumière qui sort d'un côté de sortie de la cavité résonante optique (82') opposé au côté d'entrée.

9. Dispositif récepteur selon la revendication 5, **caractérisé par** une zone absorbant la lumière (110"), disposée à l'arrière de la cavité résonante optique (82"), qui absorbe la lumière transmise à travers la cavité résonante optique.

10. Dispositif récepteur selon la revendication 5, **caractérisé en ce que** les électrodes (94', 94", 96', 96") servent en plus de miroirs de la cavité résonante optique (82', 82").

11. Dispositif récepteur selon la revendication 1, **caractérisé par** des électrodes (94, 96) couplées à l'antenne à haute fréquence (80), lesdites électrodes étant agencées de façon à générer dans le milieu électro-optiquement actif (90) un champ électrique orienté dans le sens transversal par rapport à une direction de transmission de la lumière à travers la cavité résonante optique (82), et par un polarisateur (100) disposé entre ladite au moins une fibre optique (52) et la cavité résonante optique (82), le polarisateur convertissant la lumière polarisée circulairement en lumière polarisée linéairement.

12. Dispositif récepteur selon la revendication 1, **caractérisé par** des électrodes (94', 96') couplées à l'antenne à haute fréquence (80'), lesdites électrodes étant agencées de façon à générer dans le milieu électro-optiquement actif (90') un champ électrique orienté parallèlement à une direction de transmission de la lumière à travers dans la cavité résonante optique (82'), par une fibre optique d'entrée (52) qui injecte de la lumière dans un côté d'entrée de la cavité résonante optique (82'), et par une fibre optique de sortie (54) qui reçoit la lumière qui sort d'un côté de sortie de la cavité résonante optique (82') opposé au côté d'entrée.

13. Dispositif récepteur selon la revendication 1, **caractérisé par** des électrodes (94", 96") couplées à l'antenne à haute fréquence (80"), lesdites électrodes étant agencées de façon à générer dans le milieu électro-optiquement actif (90") un champ électrique orienté parallèlement à une direction de propagation de la lumière dans la cavité résonante optique (82"), par une zone d'absorption (110"), disposée à l'arrière de la cavité résonante optique (82"), qui absorbe la lumière transmise à travers la cavité résonante optique, et par un coupleur optique (112") qui couple une lumière d'entrée à ladite au moins une fibre (52) et qui extrait de ladite au moins une fibre la lumière réfléchie par la cavité résonante optique (82").

14. Dispositif récepteur selon la revendication 1, **caractérisé en ce que** la caractéristique optique modulée est choisie dans un groupe constitué par l'indice de réfraction et l'absorption.

15. Procédé de détection d'un signal de résonance magnétique, ledit procédé comprenant les étapes consistant à coupler optiquement de la lumière à un modulateur électro-optique et à moduler la lumière couplée optiquement en utilisant une antenne à haute fréquence (80, 80', 80") afin de générer de la lumière modulée, **caractérisé en ce que** le modulateur électro-optique comprend une cavité résonante optique (82, 82', 82"), l'étape de modulation comprenant la modulation électro-optique d'un milieu électro-optiquement actif (90, 90', 90") de la cavité résonante optique en réponse à la réception du signal de résonance magnétique par l'antenne à haute fréquence, ledit procédé comprenant en plus la mesure d'une caractéristique optique de la cavité résonante optique en fonction de la lumière modulée.

16. Procédé selon la revendication 15, **caractérisé en ce que** l'antenne à haute fréquence (80, 80', 80") et la cavité résonante optique (82, 82', 82") sont disposées sur ou dans un instrument d'intervention (48), ledit procédé comprenant en plus l'introduction dans un sujet d'imagerie associé (16) d'une partie de l'instrument d'intervention (48) sur ou dans laquelle l'antenne à haute fréquence (80, 80', 80") et la cavité résonante optique (82, 82', 82") sont disposées, une fibre optique (52, 54) s'étendant à l'extérieur du sujet d'imagerie lorsque l'instrument d'intervention est introduit afin de créer un accès optique à la cavité résonante optique.

17. Procédé selon la revendication 15, **caractérisé en ce que** la modulation comprend la génération d'un champ électrique orienté dans le sens transversal par rapport à une direction de propagation de la lumière dans la cavité résonante optique (82).

18. Procédé selon la revendication 17, **caractérisé en ce que** le couplage optique de la lumière comprend la polarisation linéaire de la lumière, la lumière polarisée linéairement étant couplée optiquement à la cavité résonante optique (82).

19. Procédé selon la revendication 15, **caractérisé en ce que** la modulation comprend la génération d'un champ électrique orienté parallèlement à une direction de propagation de la lumière dans la cavité résonante optique (82', 82").

20. Procédé selon la revendication 19, **caractérisé en ce que** la mesure d'une caractéristique optique de la cavité résonante optique comprend la mesure d'une caractéristique de transmission optique de la cavité résonante optique (82').

21. Procédé selon la revendication 19, **caractérisé en ce que** la mesure d'une caractéristique optique de la cavité résonante optique comprend la mesure de l'absorption d'au moins une partie de la lumière à l'arrière de la cavité résonante optique (82") et la mesure d'une caractéristique de réflexion optique de la cavité résonante optique.

22. Scanner d'imagerie par résonance magnétique, comprenant :
un aimant (20) qui génère un champ magnétique constant dans le temps dans une zone d'imagerie ;
une ou plusieurs bobines à gradients de champ magnétique (30) qui superposent des gradients de champ magnétique sélectionnés au champ magnétique constant dans le temps dans la zone d'imagerie ;
un émetteur à haute fréquence (32, 44) qui injecte un signal d'excitation de résonance magnétique dans la zone d'imagerie,
**caractérisé par**
un dispositif récepteur (46, 46', 46") comprenant:
une cavité résonante optique (82, 82', 82") comprenant un milieu électro-optiquement actif (90, 90', 90"),
une antenne à haute fréquence (80, 80', 80") couplée au milieu électro-optiquement actif de telle façon que la réception d'un signal de résonance magnétique par l'antenne à haute fréquence module une caractéristique optique de la cavité résonante optique,
un instrument d'intervention (48) adapté pour être partiellement introduit dans un sujet d'imagerie associé (16), l'antenne à haute fréquence et la cavité résonante optique étant disposées sur une partie de l'instrument d'intervention qui est introduite dans le sujet d'imagerie associé, et
au moins une fibre optique (52, 54) couplée optiquement à la cavité résonante optique, une extrémité de ladite au moins une fibre optique s'étendant à l'extérieur du sujet d'imagerie associé lorsque l'instrument d'intervention est partiellement introduit.
